# EUROPEAN PATENT APPLICATION

(11) **EP 4 565 027 A2**
(43) Date of publication of application: **04.06.2025**
(21) Application number: 24212137.4
(22) Date of filing: 11.11.2024
(51) Int. Cl.: H10D 30/01, H10D 30/00, H10D 84/01, H10D 84/83, H10D 64/23, H10D 64/01, H10D 64/66

(54) **SEMICONDUCTOR DEVICE INCLUDING CONTACT STRUCTURES HAVING DIFFERENT DIMENSIONS**

(30) Priority: 13.11.2023 US 202363548325 P; 15.03.2024 US 202418606001
(71) Applicant: Samsung Electronics Co., Ltd., Suwon-si, Gyeonggi-do 16677 (KR)
(72) Inventor: PARK, Panjae, San Jose, CA, 95134 (US); KIM, Jintae, San Jose, CA, 95134 (US); SHIN, Hyojong, San Jose, CA, 95134 (US)
(74) Representative: Kuhnen & Wacker Patent- und Rechtsanwaltsbüro PartG mbB

(57) **Abstract**

Provided is a semiconductor device which includes: a 1^{st} channel structure (120); a 1^{st} source/drain region (145S) and a 2^{nd} source/drain region (145D) connected through the 1^{st} channel structure (120) in a 1^{st} direction; a 1^{st} gate structure (125B) on the 1^{st} channel structure (120); a 1^{st} contact structure (CA1) on the 1^{st} source/drain region (145S) and connecting the 1^{st} source/drain region (145S) to a voltage source; and a 2^{nd} contact structure (CA2) on the 2^{nd} source/drain region (145D) and connecting the 2^{nd} source/drain region (145D) to another circuit element other than a voltage source, wherein a 1^{st} contact area between the 1^{st} contact structure (CA1) and the 1^{st} source/drain region (145S) is greater than a 2^{nd} contact area between the 2^{nd} contact structure (CA2) and the 2^{nd} source/drain region (145D).

## Description

### BACKGROUND

### 1. Field

Apparatuses and methods consistent with the disclosure relate to a three-dimensionally-stacked (3D-stacked) semiconductor device, also referred to as a multi-stack semiconductor device, in which dual contact structures are formed on a lower source/drain region.

### 2. Description of Related Art

A 3D-stacked semiconductor device has been introduced in response to increased demand for an integrated circuit having a high device density and performance. The 3D-stacked semiconductor device may include a 1^{st} transistor at a 1^{st} level and a 2^{nd} transistor at a 2^{nd} level above the 1^{st} level, where each of the transistors may be a fin field-effect transistor (FinFET), a nanosheet transistor, a forksheet transistor, or any other type of transistor.

The FinFET has one or more horizontally arranged vertical fin structures as a channel structure, in which at least three surfaces of each fin structure are surrounded by a gate structure, and the nanosheet transistor is characterized by one or more nanosheet layers vertically stacked on a substrate as a channel structure and a gate structure surrounding all four surfaces of each of the nanosheet layers. The nanosheet transistor is referred to as gate-all-around (GAA) transistor, or as a multi-bridge channel field-effect transistor (MBCFET). The forksheet transistor is a combination of two nanosheet transistors with an insulation backbone structure therebetween. Nanosheet layers of each nanosheet transistor are formed at each side of the insulation backbone structure and pass through a gate structure in parallel with the backbone structure.

A backside power distribution network (BSPDN) for a semiconductor device has been introduced to address a heavy traffic of signal lines and power rails at a front side of the semiconductor device. The BSPDN may also contribute to reducing contact resistance between circuit elements formed at the front side of the semiconductor device. Here, the front side refers to a side where a transistor is formed with respect to a top surface of a substrate, and the back side refers to a side opposite to the front side. The BSPDN is formed on a back side of a semiconductor device, and may include backside metal lines, such as a buried power rail, and backside structures formed on bottom surfaces of source/drain regions of the field-effect transistor, and the backside metal lines may connect the backside contact structures to a voltage source or another circuit element for signal routing. The BSPDN may also be formed at a back side of the 3D-stacked semiconductor device to connect source/drain regions of the 2^{nd} transistor at the 2^{nd} level as well as of the 1^{st} transistor at the 1^{st} level to a voltage source.

To achieve an improved device performance of a semiconductor device such as the 3D-stacked semiconductor device, for example, how to configure contact structures to be formed on source/drain regions of a transistor structure included in the 3D-stacked semiconductor device should be considered. These contact structures are formed in a middle-of-line (MOL) process of manufacturing the semiconductor device, and thus, may be called MOL structures in view of front-end-of- line (FEOL) structures such as channel structures, source/drain regions and gate structures, back-end-of-line (BEOL) structures such as metal lines and via structures, and backside power distribution network (BSPDN) structures including backside metal lines, backside contact structures and backside power rails, etc.

Information disclosed in this Background section has already been known to or derived by the inventors before or during the process of achieving the embodiments of the present application, or is technical information acquired in the process of achieving the embodiments. Therefore, it may contain information that does not form prior art that is already known to the public.

### SUMMARY

According to an aspect of example embodiments, there is provided a semiconductor device which may include: a 1^{st} channel structure; a 1^{st} source/drain region and a 2^{nd} source/drain region connected through the 1^{st} channel structure in a 1^{st} direction; a 1^{st} gate structure on the 1^{st} channel structure; a 1^{st} contact structure on the 1^{st} source/drain region and connecting the 1^{st} source/drain region to a voltage source; and a 2^{nd} contact structure on the 2^{nd} source/drain region and connecting the 2^{nd} source/drain region to another circuit element other than a voltage source, wherein a 1^{st} contact area between the 1^{st} contact structure and the 1^{st} source/drain region is greater than a 2^{nd} contact area between the 2^{nd} contact structure and the 2^{nd} source/drain region.

According to an aspect of example embodiments, there is provided a semiconductor device which may include: a 1^{st} channel structure; a 1^{st} source/drain region and a 2^{nd} source/drain region connected through the 1^{st} channel structure in a 1^{st} direction; a 1^{st} gate structure on the 1^{st} channel structure; a 1^{st} contact structure on the 1^{st} source/drain region and connecting the 1^{st} source/drain region to a voltage source; and a 2^{nd} contact structure on the 2^{nd} source/drain region and connecting the 2^{nd} source/drain region to another circuit element other than a voltage source, wherein a 1^{st} contact length between the 1^{st} contact structure and the 1^{st} source/drain region is greater than a 2^{nd} contact length between the 2^{nd} contact structure and the 2^{nd} source/drain region in the 1^{st} direction.

According to an aspect of example embodiments, there is provided a semiconductor device which may include: a 1^{st} channel structure; a 1^{st} source/drain region and a 2^{nd} source/drain region connected through the 1^{st} channel structure in a 1^{st} direction; a 1^{st} gate structure on the 1^{st} channel structure; a 1^{st} contact structure on the 1^{st} source/drain region and connecting the 1^{st} source/drain region to a voltage source; and a 2^{nd} contact structure on the 2^{nd} source/drain region and connecting the 2^{nd} source/drain region to another circuit element other than a voltage source, wherein a 1^{st} contact height between the 1^{st} contact structure and the 1^{st} source/drain region is greater than a 2^{nd} contact height between the 2^{nd} contact structure and the 2^{nd} source/drain region in a 3^{rd} direction.

According to an aspect of example embodiments, there is provided a method of manufacturing a semiconductor device. The method may include: providing a transistor structure comprising a channel structure, a gate structure on the channel structure, a 1^{st} source/drain region, and a 2^{nd} source/drain region connected to the 1^{st} source/drain region through the channel structure in a 1^{st} direction; and forming a 1^{st} contact structure and a 2^{nd} contact structure on the 1^{st} source/drain region and the 2^{nd} source/drain region, respectively, such that the 1^{st} contact structure on the 1^{st} source/drain region has a greater contact area than the 2^{nd} contact structure on the 2^{nd} source/drain region, wherein the 1^{st} source/drain region is connected to one or more voltage sources through the 1^{st} contact structure, and the 2^{nd} source/drain region is connected to a circuit element other than the one or more voltage sources.

### BRIEF DESCRIPTION OF DRAWINGS

Example embodiments of the disclosure will be more clearly understood from the following detailed description taken in conjunction with the accompanying drawings.
FIGS. 1A-1F illustrate a 3D-stacked semiconductor device including contact structures having different contact areas on respective source/drain regions, according to one or more embodiments.
FIG. 2 illustrates a 3D-stacked semiconductor device including contact structures having different contact areas on respective source/drain regions, according to one or more embodiments.
FIG. 3 illustrates a flowchart of a method of manufacturing a semiconductor device including contact structures having different contact areas on respective source/drain regions, according to one or more embodiments.
FIG. 4 is a schematic block diagram illustrating an electronic device including a semiconductor device in which contact structures having different contact areas are formed on respective source/drain regions, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element and a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed in the description of an embodiment could be termed a 2^{nd} element in a claim without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

Herebelow, various embodiments provide contact structures of a semiconductor device to improve performance of the semiconductor device.

Reducing contact resistance and capacitance may be required with regard to contact structures formed on source/drain regions of a semiconductor device for effective power delivery to a source/drain region (source) and signal routing from and to a source/drain region (drain). However, reducing contact resistance may often be achieved at the expense of increase of contact capacitance in the semiconductor device. In other words, the two characteristics of the semiconductor device are in a trade-off relationship.

To improve or optimize device performance, contact structures connected to source/drain regions of a semiconductor device may be formed to have different sizes considering where or what purposes the contact structures are formed in the semiconductor device. For a contact structure connecting a source/drain region (source) to a voltage source VDD or VSS, contact resistance has a greater sensitivity to device performance than contact capacitance because power delivery from the voltage source may be less relevant to the contact capacitance. Thus, even if capacitance may be increased to some extent, reducing contact resistance has a greater performance effect, e.g., for reduction of power consumption. In contrast, a contact structure connecting a source/drain region (drain) to another circuit element for signal routing purposes may cause a large cross-talk effect because of continuously shaking AC signals. Thus, even if contact resistance may increase to some extent, reducing capacitance has a greater effect on performance improvement. Accordingly, a contact structure for power delivery to a source/drain region (source) may have a large contact area on the source/drain region (source) to reduce contact resistance while a contact structure connecting a source/drain region (drain) to another circuit element for signal routing purposes may have a small contact area on the source/drain region (drain) to reduce contact capacitance.

More consideration of contact resistance and capacitance may need to be given to a structure of a 3D-stacked semiconductor device having a greater complexity than a single-stack semiconductor device.

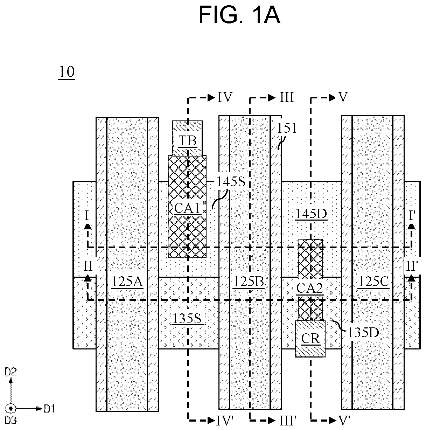

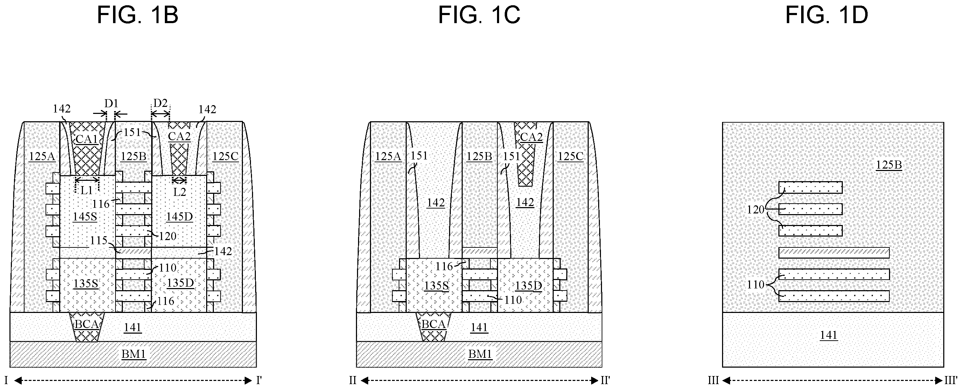

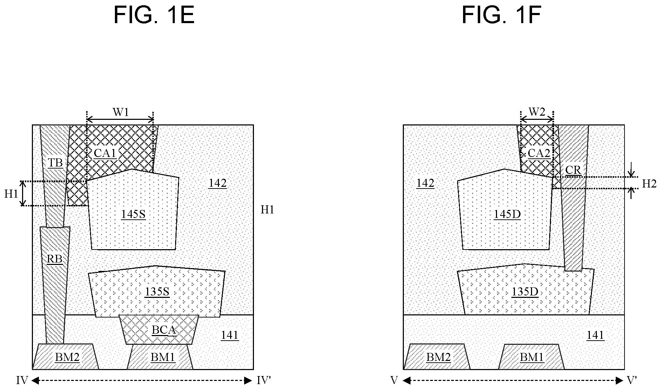

FIGS. 1A-1F illustrate a 3D-stacked semiconductor device including contact structures having different contact areas on respective source/drain regions, according to one or more embodiments.

FIG. 1A is a plan view of a 3D-stacked semiconductor device, and FIGS. 1B-1F are cross-section views of the 3D-stacked semiconductor device 10 shown in FIG. 1A taken along lines I-I', II-II', III-III, IV-IV', and V-V', respectively. It is to be understood here that FIG. 1A is provided to show a positional relationship between selected structural elements of the 3D-stacked semiconductor device 10, and thus, some structural elements such as a substrate and an isolation structure shown in FIGS. 1B-1F are not shown in FIG. 1A.

As shown in FIG. 1A, a D1 direction is a channel-length direction in which a current flows between two source/drain regions connected to each other through a channel structure, a D2 direction is a channel-width direction that intersects the D1 direction, and a D3 direction is a vertical direction that intersects the D1 and D2 directions both of which are horizontal directions.

Referring to FIGS. 1A-1F, the 3D-stacked semiconductor device 10 may include a plurality of nanosheet layers forming a 1^{st} channel structure 110 at a 1^{st} level above a backside isolation structure 141, and a plurality of nanosheet layers forming a 2^{nd} channel structure 120 at a 2^{nd} level above the 1^{st} level. A middle isolation structure 115 may be formed between the 1^{st} channel structure 110 and the 2^{nd} channel structure 120. The nanosheet layers of the channel structures 110 and 120 may have been epitaxially grown from a silicon substrate which is replaced by the backside isolation structure 141 in manufacturing the 3D-stacked semiconductor device 10.

The 1^{st} channel structure 110 may connect 1^{st} source/drain regions 135S and 135D to each other so that a current flows therebetween at a control of a gate structure 125B which surrounds the 1^{st} channel structure 110. Similarly, the 2^{nd} channel structure 120 may connect 2^{nd} source/drain regions 145S and 145D to each other so that a current flows therebetween at a control of the gate structure 125B which surrounds the 2^{nd} channel structure 120. The gate structures 125A and 125C formed at both sides of the gate structure 125B are inactive gate structures in the 3D-stacked semiconductor device 10 herein.

The 1^{st} source/drain regions 135S and 135D may be epitaxially grown from the 1^{st} channel structure 110 and the 2^{nd} source/drain regions 145S and 145D may be epitaxially grown from the 2^{nd} channel structure 120. Thus, in the 3D-stacked semiconductor device 10, the 1^{st} channel structure 110 along with the 1^{st} source/drain regions 135S, 135D and the gate structure 125B may form a 1^{st} transistor, which is a nanosheet transistor, at the 1^{st} level. Further, the 2^{nd} channel structure 120 along with the 2^{nd} source/drain regions 145S, 145D and the gate structure 125B may form a 2^{nd} transistor, which is also a nanosheet transistor, at the 2^{nd} level.

Herein, the 1^{st} source/drain regions 135S and 135D may function as a source and a drain, respectively, of the 1^{st} transistor, and 2^{nd} source/drain regions 145S and 145D may function as a source and a drain, respectively, of the 2^{nd} transistor. A frontside isolation structure 142 may be formed to surround each of the source/drain regions 135S, 135D, 145S and 145D to isolate these semiconductor structures from each other and other circuit elements.

The gate structure 125B may be a common gate structure shared by the two transistors to form a complementary metal oxide semiconductor (CMOS) device structure such as an inverter circuit. However, the disclosure is not limited thereto, an additional isolation may be formed to separate the gate structure 125B into two gate structures for the 1^{st} transistor and the 2^{nd} transistor, respectively. Gate spacers 151 formed on side surfaces of the gate structures 125A-125B may have been used to protect dummy gate structures of polycrystalline silicon from various processes in manufacturing the 3D-stacked semiconductor device 10, and remain after the dummy gate structure is replaced by the gate structures 125A-125C to prevent current leakage therefrom to other circuit elements. Inner spacers 116 may be formed between the gate structures 125A-125B, surrounding the channel structures 110 and 120, and the source/drain regions 135S, 125D, 145S and 125D to prevent current leakage therebetween.

The isolation structures 141 and 142 may each be formed of silicon oxide such as SiO₂, not being limited thereto. Each semiconductor nanosheet layer forming the channel structures 110 and 120 may be formed of silicon (Si) or silicon germanium (SiGe). The 1^{st} source/drain regions 135S, 135D and the 2^{nd} source/drain regions 145S, 145D may also be formed of Si or SiGe. However, when the 1^{st} source/drain regions 135S and 135D are formed of Si and doped with n-type impurities such as phosphorus (P), arsenic (As), antimony (Sb), etc., the 1^{st} transistor may be an n-type transistor. In contrast, when the 2^{nd} source/drain regions 145S and 145D are formed of SiGe and doped with impurities such as boron (B), gallium (Ga), indium (In), etc., the 2^{nd} transistor may be a p-type transistor.

The gate structures 125A-125C may each include a gate dielectric layer and a conductor layer. The gate dielectric layer may include a high-k material such as Hf, Al, Zr, La, Mg, Ba, Ti, Pb, and/or a combination thereof, not being limited thereto, and the conductor layer may include a metal or metal compound such as Cu, Al, Ti, Ta, W, Co, TiN, WN, TiAl, TiAlN, TaN, TiC, TaC, TiAlC, TaCN, TaSiN, or a combination thereof, not being limited thereto. The inner spacers 116 may be formed of silicon nitride (e.g., SiN, SiBCN, SiCN, SiOCN, etc.), not being limited thereto. The gate spacers 151 may be formed of silicon oxide or silicon nitride (e.g., SiO2, SiN, SiBCN, SiCN, SiOC, SiOCN, etc.), not being limited thereto, which may be different from the material(s) forming the inner spacers 116.

In the meantime, the 2^{nd} channel structure 120 may be formed to have a smaller width in the D2 direction than the 1^{st} channel structure 110. For example, while a left edge (or left side surface) of the 2^{nd} channel structure 120 is vertically aligned or coplanar with a left edge (or left side surface) of the 1^{st} channel structure 110, a right edge (or right side surface) of the 2^{nd} channel structure 120 is not vertically aligned or coplanar with a right edge (or right side surface) of the 1^{st} channel structure 110. Thus, a right side of the 2^{nd} channel structure 120 and above the 1^{st} channel structure 110 may provide a non-overlapping region where the 2^{nd} channel structure 120 does not vertically overlap the 1^{st} channel structure 110.

When the 2^{nd} channel structure 120 has the smaller width than the 1^{st} channel structure 110 in the D2 direction, each of the 2^{nd} source/drain regions 145S and 145D epitaxially grown from the 2^{nd} channel structure 120 may also have a smaller width in the D2 direction than each of the 1^{st} source/drain regions 135S and 135D epitaxially grown from the 1^{st} channel structure 110, respectively. For example, while a left edge of the 2^{nd} source/drain region 145D is vertically aligned or coplanar with a left edge of the 1^{st} source/drain region 135D therebelow, a right edge of the 2^{nd} source/drain region 145D is not vertically aligned or coplanar with a right edge of the 1^{st} source/drain region 135D. Thus, a right side of the 2^{nd} source/drain region 145D above the 1^{st} source/drain region 135D may provide a non-overlapping region where the 2^{nd} source/drain region 145D does not vertically overlap the 1^{st} source/drain region 135D. The foregoing width differences between the source/drain regions are provided to form a contact structure of the 1^{st} source/drain region 135D on at least a portion of the top surface of the 1^{st} source/drain region 135D through the non-overlapping region in a limited area, as shown in FIG. 1F.

Each of the 1^{st} source/drain regions 135S and 135D and the 2^{nd} source/drain regions 145S and 145D may have a contact structure formed thereon for connection to a voltage source or another circuit element therethrough. The 1^{st} source/drain region 135S may have a backside contact structure BCA formed on a bottom surface thereof in the backside isolation structure 141. The backside contact structure BCA may connect the 1^{st} source/drain regions 135S to a negative voltage source VSS though a backside metal line BM1 formed in the backside isolation structure 141. The 1^{st} source/drain region 135D may have a 1^{st} contact structure CR formed on a right portion of a top surface. The 1^{st} contact structure CR may connect the 1^{st} source/drain region 135D to the 2^{nd} source/drain region 145D thereabove through a 2^{nd} contact structure CA2 formed on an upper-right portion of the 2^{nd} source/drain region 145D. The 2^{nd} source/drain region 145S may have a 2^{nd} contact structure CA1 formed on a left-upper portion of the 2^{nd} source/drain region 145S. The 2^{nd} contact structure CA1 may connect the 2^{nd} source/drain region 145S to a positive voltage source VDD through a 1^{st} front-side via RB, a 2^{nd} front-side via TB, and a backside metal line BM2.

A gate contact structure (not shown) may be formed on the gate structure 125 to receive a gate input signal through a metal line included in a back-end-of-line (BEOL) layer.

Herein, a source/drain region being connected to a voltage source refers to the source/drain region being connected to the voltage source without through another source/drain region or a gate structure, and a source/drain region being connected to another circuit element refers to the source/drain region being connected to the other circuit element such as another source/drain region without through a voltage source.

Each of the contact structures BCA, CR, CA1, CA2, the vias RB and TB, and the backside metal lines BM1 and BM2 may be formed of a metal or metal compound such as Cu, W, Al, Ru, Mo, Co, and/or a combination thereof, not being limited thereto.

In the meantime, to further improve performance of the 3D-stacked semiconductor device 10, the 2^{nd} contact structure CA1 may be formed to have a large contact area on the 2^{nd} source/drain region 145S to decrease contact resistance therebetween while the 2^{nd} contact structure CA2 may be formed to have a small contact area on the 2^{nd} source/drain region 145D to reduce contact capacitance therebetween.

For example, the 2^{nd} contact structure CA1 may have a large contact length L1, a large contact width W1 and a large contact height H1 on the 2^{nd} source/drain region 145S, while the 2^{nd} contact structure CA1 may have a small contact length L2, a small contact width W2 and a small contact height H2 on the 2^{nd} source/drain region 145D, in the respective D1-D3 directions. However, the disclosure is not limited thereto. According to one or more other embodiments, the contact area difference may be implemented by differentiating only one or two of the contact length, the contact width and the contact height. Further, a large contact area may be implemented by increasing only one or two of the contact length, the contact width and the contact height even if the other one or two are decreased. Likewise, a small contact area may be implemented by decreasing one or two of the contact length, the contact width and the contact height even if the other one or two are increased.

The foregoing contact area difference between the two 2^{nd} contact structures CA1 and CA2 is provided because the 2^{nd} contact structure CA1 is configured to receive and deliver power from the voltage source VDD to the 2^{nd} source/drain region 145S while the 2^{nd} contact structure CA2 is configured to transmit or receive a routing signal to or from another circuit element such as the 1^{st} source/drain region 135D of the 1^{st} transistor at the 1^{st} level.

As described earlier, power delivery from the voltage source VDD to the 2^{nd} source/drain region 145S may be more effective and efficient when the 2^{nd} contact structure CA1 has a small contact resistance on the 2^{nd} source/drain region 145S. Thus, power consumption at the 2^{nd} source/drain region 145S may be reduced due to the small contact resistance caused by the large contact area. At this time, increase of capacitance between the 2^{nd} contact structure CA1 and the 2^{nd} source/drain region 145S because of the large contact area may not affect performance of the 3D-stacked semiconductor device 10 as much as the small contact resistance contributes to performance improvement in the 3D-stacked semiconductor device 10.

In contrast, the small contact capacitance caused by the small contact area between the 2^{nd} contact structure CA2 and the 2^{nd} source/drain region 145D may prevent increase of a switching time of an AC signal transmitted to or received from the 2^{nd} source/drain region 145D, thereby to reduce power consumption. At this time, increase of contact resistance between the 2^{nd} contact structure CA2 and the 2^{nd} source/drain region 145D because of the small contact area may not affect performance of the 3D-stacked semiconductor device 10 as much as the small contact capacitance contributes to improving performance of the 3D-stacked semiconductor device 10.

To implement a large contact area on the 2^{nd} source/drain region 145S and a small contact area on the 2^{nd} source/drain region 145D, a bottom surface of the 2^{nd} contact structure CA1 on the 2^{nd} source/drain region 145S may have a length L1 while a bottom surface of the 2^{nd} contact structure CA2 on the 2^{nd} source/drain region 145D may have a length L2 which is smaller than the length L1 in the D1 direction, as shown in FIG. 1B.

Further, when the contact length L2 of the 2^{nd} contact structure CA2 on the 2^{nd} source/drain region 145D is formed to be smaller than the contact length L1 of the 2^{nd} contact structure CA1 on the 2^{nd} source/drain region 145S, a distance D2 between the 2^{nd} contact structure CA2 and the gate structure 125B may be greater than a distance D1 between the 2^{nd} contact structure CA1 and the gate structure 125B. Thus, fringe capacitance between the 2^{nd} contact structure CA2 and the gate structure 125B may be smaller than that between the 2^{nd} contact structure CA1 and the gate structure 125B. Thus, device performance may be additionally improved by decreasing an AC signal switching time, reducing power consumption, and reducing influence on a gate threshold voltage of the gate structure 125B.

The 2^{nd} contact structures CA1 and CA2 may be formed by patterning the frontside isolation structure 142 on the 2^{nd} source/drain regions 145S and 145D between the gate structures 125A-125C. This patterning may expose top surfaces of the 2^{nd} source/drain regions 145S and 145D by the lengths L1 and L2 as shown in FIG. 1B through, for example, photolithography, masking, and etching such as dry and/or wet etching. Subsequently, a metal or metal compound such as Cu, W, Al, Ru, Mo, Co, and/or a combination thereof, may be deposited in the patterned frontside isolation structure 142 through, for example, physical vapor deposition (PVD), chemical vapor deposition (CVD), plasma enhanced chemical vapor deposition (PECVD), or a combination thereof, followed by planarization such as chemical-mechanical polishing (CMP), not being limited thereto.

However, the 2^{nd} contact structure CA1 and the 2^{nd} contact structure CA2 may be formed in a self-aligned manner according to one or more embodiments.

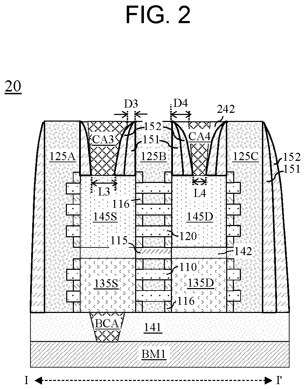

FIG. 2 illustrates a 3D-stacked semiconductor device including contact structures having different contact areas on respective source/drain regions, according to one or more embodiments.

Referring to FIG. 2, a 3D-stacked semiconductor device 20 may include the same structural elements included in the 3D-stacked semiconductor device 10 of FIGS. 1A-1F except that 2^{nd} contact structures CA3 and CA4 may be formed in a frontside isolation structure 242 based on extra gate spacers 152 on side surfaces of the gate spacers 151. Herebelow, while duplicate descriptions of the same structural elements are omitted herein, different aspects of the 3D-stacked semiconductor device 20 in view of the 3D-stacked semiconductor device 10 are described.

In the 3D-stacked semiconductor device 10 of FIGS. 1A-1F, the gate spacers 151 may be formed on the side surfaces of the gate structures 125A-125C and on the 2^{nd} source/drain regions 145S and 145D, and the frontside isolation structure 142 may be formed between the gate spacers 151 on the 2^{nd} source/drain regions 145S and 145D. Further, in the 3D-stacked semiconductor device 10, the 2^{nd} contact structures CA1 and CA2 may be formed through the frontside isolation structure 142 to contact the top surfaces of the 2^{nd} source/drain regions 145S and 145D, respectively. Thus, side surfaces of the 2^{nd} contact structures CA1 and CA2 may be surrounded by the frontside isolation structure 142, and the contact lengths L1 and L2 of the 2^{nd} contact structures CA1 and CA2 on the 2^{nd} source/drain regions 145S and 145D may be defined, respectively, in the frontside isolation structure 142.

In contrast, in the 3D-stacked semiconductor device 20 of FIG. 2, the extra gate spacers 152 may be formed along the side surfaces of the gate spacers 151 on the gate structures 125B and 125C and on the 2^{nd} source/drain regions 145S and 145D. The extra gate spacers 152 may contact the side surfaces of these gate spacers 151, and bottom surfaces of the extra gate spacers 152 may contact top surfaces of the 2^{nd} source/drain regions 145S and 145D. Here, the extra gate spacers 152 may be formed on the 2^{nd} source/drain regions 145S and 145D such that a contact length L3 of the 2^{nd} contact structure CA1 on the 2^{nd} source/drain region 145S is defined by a distance between the gate spacer 151 and the extra gate spacer 152 on the 2^{nd} source/drain region 145D, and a contact length L4 of the 2^{nd} contact structure CA2 on the 2^{nd} source/drain region 145D is defined by a distance between the extra gate spacers 152 on the 2^{nd} source/drain region 145D.

Due to the extra gate spacers 152, the frontside isolation structure 242 may be formed between the gate spacer 151 and the extra gate spacer 152 on the 2^{nd} source/drain region 145S, and between the extra gate spacers 152 on the 2^{nd} source/drain region 145D. Further, the 2^{nd} contact structures CA3 and CA4 may be formed through the frontside isolation structure 242 to contact the top surfaces of the 2^{nd} source/drain regions 145S and 145D, respectively, as in the 3D-stacked semiconductor device 10 of FIGS. 1A-1F. However, in the 3D-stacked semiconductor device 20, although the 2^{nd} contact structures CA3 and CA4 may formed through the frontside isolation structure 242, lower edge portions of the 2^{nd} contact structure CA3 may contact the gate spacer 151 and the extra gate spacer 152 on the 2^{nd} source/drain region 145S without the frontside isolation structure 242 therebetween, and lower edge portions of the 2^{nd} contact structure CA4 may contact the extra gate spacers 152 on the 2^{nd} source/drain region 145D without the frontside isolation structure 242 therebetween. Thus, the contact lengths L3 and L4 of the 2^{nd} contact structures CA3 and CA4 on the 2^{nd} source/drain regions 145S and 145D may be defined, respectively, by the gate spacer 151 and the extra gate spacers 152.

Here, the frontside isolation structure 242 may have been patterned in a self-aligning manner due to the extra gate spacers 152 as well as the gate spacer 151 to provide respective contact holes to expose respective contact areas including the contact lengths L3 and L4 on the 2^{nd} source/drain regions 145S and 145D. For example, a combination of chlorotrifluoride (CHF₃) and hydrogen (H₂) may be used an etchant for reactive ion etching (RIE) to selectively etch the frontside isolation structure 242 formed of silicon oxide such as SiO₂ against silicon nitride such as SiBCN. Thus, the frontside isolation structure 242 may be removed at around lower edges of the gate spacer 151 and the extra gate spacers 152 on the 2^{nd} source/drain regions 145S and 145D, so that the lower edge portions of the 2^{nd} contact structures CA3 and CA4 may contact the gate spacer 151 and the extra gate spacers 152 on the 2^{nd} source/drain regions 145S and 145D as described above without the frontside isolation structure 242 therebetween.

Structurally, the 3D-stacked semiconductor device 20 may still be characterized by a difference in contact areas of the 2^{nd} contact structures CA3 and CA4 on the 2^{nd} source/drain regions 145D and 145S, respectively. As shown in FIG. 2, the 2^{nd} contact structure CA3 on the 2^{nd} source/drain region 145S may be have a greater area than the 2^{nd} contact structure CA4 on the 2^{nd} source/drain region 145D considering that the 2^{nd} contact structure CA3 connects the 2^{nd} source/drain region 145S to the voltage source VDD and the 2^{nd} contact structure CA4 connects the 2^{nd} source/drain region 145D to another circuit element such as the 1^{st} source/drain region 135D of the 1^{st} transistor at the 1^{st} level.

For example, the contact length L3 of a bottom surface of the 2^{nd} contact structure CA1 defined by the gate spacer 151 and the extra gate spacer 152 on the 2^{nd} source/drain region 145S may be greater than the contact length L4 of a bottom surface of the 2^{nd} contact structure CA2 defined by the extra gate spacers 152 on the 2^{nd} source/drain regions 145D by a length of the extra gate spacer 152 in the D1 direction.

As in the 3D-stacked semiconductor device 10, the contact area difference in the 3D-stacked semiconductor device 20 may be implemented considering that contact resistance is the priority factor for power delivery performance by the 2^{nd} contact structure CA3 to the 2^{nd} source/drain region 145S, and contact capacitance is the priority factor for signal routing performance by the 2^{nd} contact structure CA4 with respect to the 2^{nd} source/drain region 145D. As described earlier, the 2^{nd} contact structure CA3 configured to deliver power from the voltage source VDD to the 2^{nd} source/drain region 145S is less sensitive to contact capacitance, while the 2^{nd} contact structure CA4 configured to receive or transmit a signal from or to the 2^{nd} source/drain region 145D for signal routing purposes rather than power delivery to the 2^{nd} source/drain region 145D is less sensitive to contact resistance.

Further, when the contact length L4 of the 2^{nd} contact structure CA4 on the 2^{nd} source/drain region 145D is formed to be smaller than the contact length L3 of the 2^{nd} contact structure CA3 on the 2^{nd} source/drain region 145S, a distance D4 between the 2^{nd} contact structure CA4 and the gate structure 125B may be greater than a distance D3 between the 2^{nd} contact structure CA3 and the gate structure 125B. Thus, fringe capacitance between the 2^{nd} contact structure CA4 and the gate structure 125B may be smaller than that between the 2^{nd} contact structure CA3 and the gate structure 125B. Thus, device performance may be additionally improved by decreasing an AC signal switching time, reducing power consumption, and reducing influence on a gate threshold voltage of the gate structure 125B.

In the above embodiments, the 3D-stacked semiconductor devices 10 and 20 are described as being formed by nanosheet transistors. However, the disclosure is not limited thereto, and at least one of the 1^{st} and 2^{nd} transistors at the 1^{st} and 2^{nd} levels, respectively, in each of the 3D-stacked semiconductor devices 10 and 20 may be formed by a different type of transistor such as FinFET and forksheet transistor, according to one or more embodiments.

Further, the 1^{st} and 2^{nd} transistors are described as p-type and n-type transistors. However, the disclosure is not limited thereto, and each of the 1^{st} and 2^{nd} transistors may be of either p-type or n-type, according to one or more embodiments.

It is also to be understood that the above embodiments of differentiating contact structures by purposes or functions of the contact structures may apply to a 3D-stacked semiconductor device in which a width of a channel structure and a width of a source/drain region of a 1^{st} transistor at a 1^{st} level is the same or substantially same as those of a 2^{nd} transistor at a 2^{nd} level.

It is further to be understood that the above embodiments of differentiating contact structures by purposes or functions of the contact structures may apply to a single-stack semiconductor device.

Herebelow, a method of manufacturing a semiconductor device corresponding to the 3D-stacked semiconductor device 20 is provided.

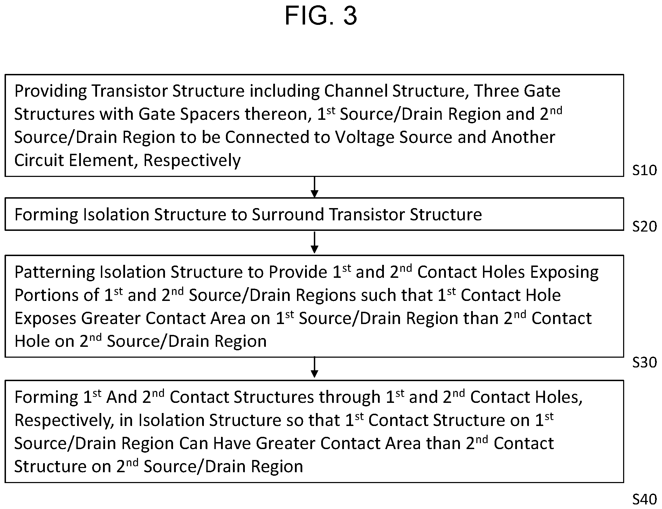

FIG. 3 illustrates a flowchart of a method of manufacturing a semiconductor device including contact structures having different contact areas on respective source/drain regions, according to one or more embodiments.

The semiconductor device manufactured according to the flowchart of FIG. 3 may correspond to the 3D-stacked semiconductor device 10 or 20 shown in FIGS. 1A-1F and 2, and thus, materials and functions of structural elements of the semiconductor device may be the same as those of the 3D-stacked semiconductor device 10 or 20 described above, and thus, duplicate descriptions thereof are omitted herein.

In step S10, a transistor structure may be provided, including a channel structure, three gate structures with gate spacers thereon, a 1^{st} source/drain region, and a 2^{nd} source/drain region to be connected to a voltage source and another circuit element, respectively.

In the transistor structure provided in this step, the 1^{st} and 2^{nd} source/drain regions may be formed by epitaxial growth from the channel structure, and the gate structures may be formed by replacing dummy gate structures on the channel structure. The gate spacers may be formed on respective side surfaces of the dummy gate structures to protect the dummy gate structures from various operations including formation of the 1^{st} and 2^{nd} source/drain regions, and remain after the dummy gate structures are replaced by the gate structures at least to prevent current leakage from the gate structures when the semiconductor device is completed and active.

The channel structure may be formed of a plurality of nanosheet semiconductor layers to form the transistor structure as a nanosheet transistor or a forksheet transistor, or may be formed of one or more fin structures to form the transistor structure as a FinFET.

The 1^{st} source/drain region may be configured to receive a power from a voltage source, and the 2^{nd} source/drain region may be configured to receive or transmit an AC signal from or to another circuit element in the semiconductor device or outside the semiconductor device.

In step S20, an isolation structure may be formed to surround the transistor structure provided in the previous step such that the isolation structure is formed on the 1^{st} and 2^{nd} source/drain regions.

The isolation structure may be formed to isolate the 1^{st} and 2^{nd} source/drain regions from each other and other circuit elements. The formation of the isolation structure may be performed through, for example, PVD, CVD, PECVD, or a combination thereof, followed by planarization such as chemical-mechanical polishing (CMP), not being limited thereto.

In step S30, the isolation structure may be patterned to provide 1^{st} and 2^{nd} contact holes exposing portions of the 1^{st} and 2^{nd} source/drain regions such that the 1^{st} contact hole exposes a greater contact area on the 1^{st} source/drain region than the 2^{nd} contact hole on the 2^{nd} source/drain region.

Here, the isolation structure may be patterned based on hard mask structures formed thereon such that the 1^{st} contact hole exposes the 1^{st} source/drain region by a 1^{st} contact area and the 2^{nd} contact hole exposes the 2^{nd} source/drain region by a 2^{nd} contact area. The 1^{st} and 2^{nd} contact holes may be through holes, and the 1^{st} contact area is greater than the 2^{nd} contact area. The 1^{st} contact area can be greater than the 2^{nd} contact area by controlling at least one of a contact length, a contact width and a contact height formed by each of the 1^{st} and the 2^{nd} contact holes. The patterning operation in this step may be performed through, for example, dry etching and/or wet etching.

In step S40, the 1^{st} and 2^{nd} contact structures may be formed through the 1^{st} and 2^{nd} contact holes in the isolation structure, respectively, so that the 1^{st} contact structure on the 1^{st} source/drain region can have a greater contact area than the 2^{nd} contact structure on the 2^{nd} source/drain region.

When the 1^{st} contact area on the 1^{st} source/drain region is greater than the 2^{nd} contact area on the 2^{nd} source/drain region, the 1^{st} contact structure connecting the 1^{st} source/drain region to a voltage source may have a smaller contact resistance and a greater contact capacitance with respect to the 1^{st} source/drain region, while the 2^{nd} contact structure connecting the 2^{nd} source/drain region to another circuit element such as another source/drain region or gate structure may have a smaller contact capacitance and a greater contact resistance with respect to the 2^{nd} source/drain region.

Thus, the semiconductor device manufactured through the above steps may have an improved device performance in power delivery and signal routing.

In the meantime, prior to the formation of the isolation structure on the transistor structure in step S20, extra gate spacers may be formed on side surfaces of selected two gate structures among the three gate structures as optional step S15. For example, by forming the extra gate spacers on the side surfaces of two gate spacers on or adjacent to the 2^{nd} source/drain region in this step, the isolation structure can be patterned in a self-aligning manner to form a 2^{nd} contact hole based on the extra gate spacers thereon and form a 1^{st} contact hole based on the extra gate spacer and the gate spacer on the non-selected gate structure.

Due to the extra gate spacers, the 2^{nd} contact hole may expose a smaller 2^{nd} contact area on the 2^{nd} source/drain region than a 1^{st} contact area exposed by the 1^{st} contact hole on the 1^{st} source/drain region. Thus, the extra gate spacers may facilitate the formation of the 1^{st} and 2^{nd} contact structures having different contact areas on the 1^{st} and 2^{nd} source/drain regions, respectively.

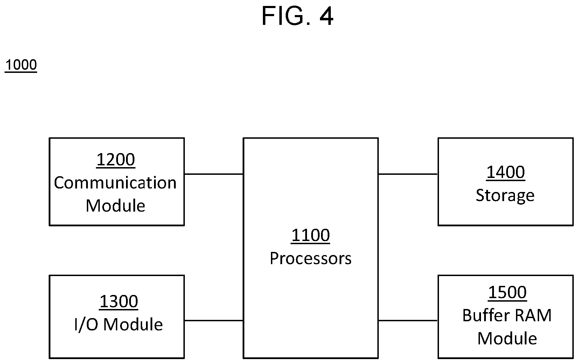

FIG. 4 is a schematic block diagram illustrating an electronic device including a semiconductor device in which contact structures having different contact areas are formed on respective source/drain regions, according to one or more embodiments. This semiconductor device may be one of the 3D-stacked semiconductor devices 10 and 20 shown in FIGS. 1A-1F and 2 or a semiconductor device manufactured according to the method described in reference to FIG. 3.

Referring to FIG. 4, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 4, the electronic device 1000 may further include at least one sensor such as an image sensor.

At least one component in the electronic device 1000 may be formed based on a semiconductor device including contact structures having different contact areas on respective source/drain regions, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} channel structure (120);
a 1^{st} source/drain region (145S) and a 2^{nd} source/drain region (145D) connected through the 1^{st} channel structure (110) in a 1^{st} direction;
a 1^{st} gate structure (125B) on the 1^{st} channel structure (120);
a 1^{st} contact structure (CA1) on the 1^{st} source/drain region (145S) and for connecting the 1^{st} source/drain region (145S) to a voltage source; and
a 2^{nd} contact structure (CA2) on the 2^{nd} source/drain region (145D) and for connecting the 2^{nd} source/drain region (145D) to another circuit element other than a voltage source,
wherein a 1^{st} contact area between the 1^{st} contact structure (CA1) and the 1^{st} source/drain region (145S) is greater than a 2^{nd} contact area between the 2^{nd} contact structure (CA2) and the 2^{nd} source/drain region (145S).

2. The semiconductor device of claim 1, wherein one or more of a 1^{st} contact length (L1) in the 1^{st} direction, a 1^{st} contact width (W1) in a 2^{nd} direction, and a 1^{st} contact height (H1) in a 3^{rd} direction between the 1^{st} contact structure (CA1) and the 1^{st} source/drain region (145S) is greater than one or more of a 2^{nd} contact length (L2) in the 1^{st} direction, a 2^{nd} contact width (W2) in a 2^{nd} direction, and a 2^{nd} contact height (H2) in a 3^{rd} direction between the 2^{nd} contact structure (CA2) and the 2^{nd} source/drain region (CA2), respectively.

3. The semiconductor device of claim 1, wherein a 1^{st} contact length (L1) in the 1^{st} direction between the 1^{st} contact structure (CA1) and the 1^{st} source/drain region (145S) is greater than a 2^{nd} contact length (L2) in the 1^{st} direction between the 2^{nd} contact structure (CA2) and the 2^{nd} source/drain region (145D).

4. The semiconductor device of any one of claims 1 to 3, wherein an isolation structure (142) is disposed at a side surface of each of the 1^{st} contact structure (CA1) and the 2^{nd} contact structure (CA2).

5. The semiconductor device of any one of claims 1 to 3, wherein at least one gate spacer (151, 152) is disposed to contact at least a portion of a side surface of each of the 1^{st} contact structure (CA1) and the 2^{nd} contact structure (CA2).

6. The semiconductor device of claim 5, wherein the at least a portion of a side surface of each of the 1^{st} contact structure (CA1) and the 2^{nd} contact structure (CA2) is a lower side surface of each of the 1^{st} contact structure (CA1) and the 2^{nd} contact structure (CA2) close to each of the 1^{st} source/drain region (145S) and the 2^{nd} source/drain region (145D).

7. The semiconductor device of claim 5 or 6, wherein, in the first direction, a length of the at least one gate spacer contacting the side surface of the 1^{st} contact structure (CA1) is smaller than a length of the at least one gate spacer contacting the side surface of the 2^{nd} contact structure (CA2).

8. The semiconductor device of claim 3, further comprising:
a 2^{nd} gate structure (125A) at a side of the 1^{st} gate structure (145S) in the 1^{st} direction;
a 3^{rd} gate structure (125C) at an opposite side of the 1^{st} gate structure (145S) in the 1^{st} direction;
wherein the 1^{st} contact length (L1) is defined by a distance between a gate spacer (151) on a side surface of the 2^{nd} gate structure (125A) and an extra gate spacer (152) on a gate spacer (151) on a side surface of the 1^{st} gate structure (CA1), and
wherein the 2^{nd} contact length (L2) is defined by a distance between an extra gate spacer (152) on a gate spacer (151) on another side surface of the 1^{st} gate structure (151) and an extra gate spacer (152) on a gate spacer (151) on a side surface of the 3^{rd} gate structure (125C).

9. The semiconductor device of any one of claims 1 to 8, wherein a 1^{st} distance between the 1^{st} contact structure (CA1) and the 1^{st} gate structure (125B) is smaller than a 2^{nd} distance between the 2^{nd} contact structure (145D) and the 1^{st} gate structure (125B).

10. The semiconductor device of any one of claims 1 to 9, further comprising:
a 2^{nd} channel structure (110); and
a 3^{rd} source/drain region (135S) and a 4^{th} source/drain region (135D) respectively overlapping the 1^{st} source/drain region (145S) and the 2^{nd} source/drain region (145D) in a 3^{rd} direction intersecting the 1^{st} direction, the 3^{rd} source/drain region (135S) and the 4^{th} source/drain region (135D) being connected through the 2^{nd} channel structure (110) in the 1^{st} direction;
a 4^{th} contact structure (CR) on the 4^{th} source/drain region (145D) connecting the 4^{th} source/drain region (135D) to the 2^{nd} source/drain region (145D) through the 2^{nd} contact structure (CA2).

11. The 3D-stacked semiconductor device of claim 10, further comprising:
a 3^{rd} contact structure (BCA) on the 3^{rd} source/drain region (135S) connecting the 3^{rd} source/drain region (135S) to another voltage source.

12. A method of manufacture a semiconductor device, the method comprising:
providing a transistor structure comprising a channel structure (120), a 1^{st} gate structure (125B) on the channel structure (120), a 1^{st} source/drain region (145S), and a 2^{nd} source/drain region (145D) connected to the 1^{st} source/drain region (145S) through the channel structure (120) in a 1^{st} direction; and
forming a 1^{st} contact structure (CA1) and a 2^{nd} contact structure (CA2) on the 1^{st} source/drain region (145S) and the 2^{nd} source/drain region (145D), respectively, such that the 1^{st} contact structure (CA1) on the 1^{st} source/drain region (145S) has a greater contact area than the 2^{nd} contact structure (CA2) on the 2^{nd} source/drain region (145D),
wherein the 1^{st} source/drain region (145S) is connected to one or more voltage sources through the 1^{st} contact structure (CA1), and the 2^{nd} source/drain region (145D) is connected to a circuit element other than the one or more voltage sources.

13. The method of claim 12, wherein the 1^{st} gate structure (125B) comprises a gate spacer (151) on a side surface thereof,
wherein the providing the transistor structure comprises forming an extra gate spacer (152) on the gate spacer (151), and
wherein the forming the 1^{st} contact structure (CA1) and the 2^{nd} contact structure (CA2) is performed based on the gate spacer (151) and the extra gate spacer (152).

14. The method of claim 12 or 13, further comprising a 2^{nd} gate structure (125A) and a 3^{rd} gate structure (125C) on the channel structure (120) with gate spacers (151) on side surfaces thereof, respectively,
wherein the providing the transistor structure comprises forming extra gate spacers (151) on the side surfaces of the 2^{nd} and 3^{rd} gate structures (125A, 125C),
wherein the forming the 1^{st} contact structure (CA1) is performed based on a gate spacer (151) on a side surface of the 1^{st} gate structure (125B) and an extra gate spacer (152) on the gate spacer (151) on a side surface of the 2^{nd} gate structure, and
wherein the forming the 2^{nd} contact structure (CA2) is performed based on an extra gate spacer (152) on a gate spacer (151) on another side surface of the 2^{nd} gate structure (125A) and an extra gate spacer (152) on a gate spacer (151) on a side surface of the 3^{rd} gate structure (125C).

15. The method of any one of claims 12 to 14, wherein the 1^{st} contact structure (CA1) and the 2^{nd} contact structure (CA2) are formed on the 1^{st} source/drain region (145S) and the 2^{nd} source/drain region (CA1), respectively, such that the 1^{st} contact structure (CA1) on the 1^{st} source/drain region (145S) has a greater contact length (L1) than the 2^{nd} contact structure (CA2) on the 2^{nd} source/drain region (145D) in the 1^{st} direction and/or such that a 1^{st} distance between the 1^{st} contact structure (CA1) and the 1^{st} gate structure (125B) is smaller than a 2^{nd} distance between the 2^{nd} contact structure (CA2) and the 1^{st} gate structure (125B).
